# EUROPEAN PATENT APPLICATION

(11) **EP 3 474 296 A1**
(43) Date of publication of application: **24.04.2019**
(21) Application number: 17813382.3
(22) Date of filing: 15.06.2017
(51) Int. Cl.: H01B 12/06, C01G 1/00, H01B 13/00, H01F 6/06

(54) **OXIDE SUPERCONDUCTING WIRE AND METHOD FOR MANUFACTURING SAME**

(30) Priority: 16.06.2016 JP 2016119838
(71) Applicant: Fujikura Ltd., Tokyo 135-8512 (JP)
(72) Inventor: IGARASHI, Mitsunori, Sakura-shi Chiba 285-8550 (JP)
(74) Representative: Cabinet Plasseraud
(86) International application number: PCT/JP2017/022106
(87) International publication number: WO 2017/217487

(57) **Abstract**

The oxide superconducting wire includes: a superconducting layer formed on a substrate, wherein the superconducting layer includes a structure in which artificial pin rods having different lengths are dispersed on a plane parallel to a substrate surface of the substrate.

## Description

### Technical Field

The present invention relates to an oxide superconducting wire and a method for manufacturing the same.

Priority is claimed on Japanese Patent Application No. 2016-119838, filed June 16, 2016, the content of which is incorporated herein by reference.

### Background Art

In recent years, the development of a superconducting wire using a Y-based oxide superconductor represented by the general formula REBa₂Cu₃O_{X} (RE123) has been advanced. It is well known that when a hetero-phase component is intentionally introduced into a superconducting layer in the Y-based superconducting wire, the hetero-phase component serves as pinning centers, and the critical current characteristic of the superconducting wire in the magnetic field improves. These intentionally introduced pinning centers are called artificial pins. As an artificial pin material, BaZrO₃ (BZO), BaHfO₃ (BHO), Y₂O₃, and the like are known.

For example, in a case where the introduction of BZO or BHO is carried out through a gas phase method (PLD method, CVD method, or the like), rod-shaped artificial pins are precipitated in the superconducting layer, and in a case where the introduction is carried out through a liquid phase method (MOD method or the like), particulate artificial pins are precipitated in the superconducting layer. In both cases of rod-shaped and particulate pins, these artificial pins are usually randomly dispersed in the superconducting layer. For example, in the PLD method, a superconductor target in which an artificial pin material is dispersed is used, and the target is continuously irradiated with a laser, whereby a superconducting layer in which artificial pins are dispersed is film-formed on a substrate.

Although the above is a general method for introducing the artificial pins, known documents report ideas for introducing the artificial pins.

Patent Document 1 discloses a structure in which a first superconducting film containing no impurities and a second superconducting film containing impurities are alternately layered.

Patent Document 2 discloses a structure in which columnar crystals containing Ba are arranged discontinuously in the film thickness direction in the superconducting layer.

Patent Document 3 discloses a structure in which columnar or bar-shaped BZO crystals are dispersed in a GdBCO superconducting layer in a state where the crystals incline with respect to a c-axis of the superconducting crystal, and where the longitudinal directions of the adjacent crystals twist.

### Document of Related Art

### Patent Document

[Patent Document 1] Japanese Unexamined Patent Application, First Publication No. 2009-283372
[Patent Document 1] Japanese Unexamined Patent Application, First Publication No. 2008-130291
[Patent Document 1] Japanese Unexamined Patent Application, First Publication No. 2012-033402

### Summary of Invention

### Technical Problem

In a case where rod-shaped artificial pins are introduced into the superconducting layer through a normal artificial pin introduction method, since the rods grow in the c-axis direction of the superconducting layer, an especially strong pinning force is obtained when a magnetic field is applied in the c-axis direction. However, as the angle (magnetic field application angle) of the magnetic field application direction with respect to the c-axis direction approaches 90°, the introduction of the artificial pins may not contribute much to the pinning.

The present invention is made in view of the above circumstances, and an object is to provide an oxide superconducting wire, which can improve a critical current density (Jc) at various magnetic field application angles, and a method for manufacturing the oxide superconducting wire.

### Solution to Problem

In order to solve the above problems, a first aspect of the present invention is an oxide superconducting wire including: a superconducting layer formed on a substrate, wherein the superconducting layer includes a structure in which artificial pin rods having different lengths are dispersed on a plane parallel to a substrate surface of the substrate.

A second aspect of the present invention is that in the oxide superconducting wire of the first aspect, the superconducting layer includes a structure in which a layer having a high density of the artificial pin rods in a plane parallel to the substrate surface and a layer having a low density of the artificial pin rods in a plane parallel to the substrate surface are alternately layered in a direction perpendicular to the substrate surface.

A third aspect of the present invention is that in the oxide superconducting wire of the first or second aspect, the artificial pin rods are formed of BaMO₃ (M is a tetravalent metal) or Re₂O₃ (RE is a rare earth element).

In order to solve the above problems, a fourth aspect of the present invention is a method for manufacturing the oxide superconducting wire of any one of the first to third aspects, the method including: forming the superconducting layer on the substrate through a pulsed laser deposition (PLD) method by causing a laser to scan an irradiation position, in a direction crossing a traveling direction of the substrate, of a first target and a second target integrally or separately juxtaposed, the first target containing a material to form the artificial pin rods, the second target containing a material to form an oxide superconductor and no material to form the artificial pin rods.

### Effects of Invention

According to the oxide superconducting wire of the present invention, since a superconducting layer in which long and short artificial pin rods are mixed and dispersed is provided, the pinning effect can be obtained at various magnetic field application angles, and the critical current density (Jc) can be improved. In addition, according to the method for manufacturing the oxide superconducting wire of the present invention, a superconducting layer in which long and short artificial pin rods are mixed and dispersed can be film-formed on a substrate.

### Brief Description of Drawings

FIG. 1 is a cross-sectional view schematically showing an example of an oxide superconducting wire of the present invention.
FIG. 2 is a perspective view showing an example of a film-forming process of a manufacturing method of the present invention.
FIG. 3 is a cross-sectional view showing an example of a layered body of the oxide superconducting wire.

FIG. 4 is a graph showing an example of magnetic field angle dependence of Jc of the oxide superconducting wire.

### Description of Embodiments

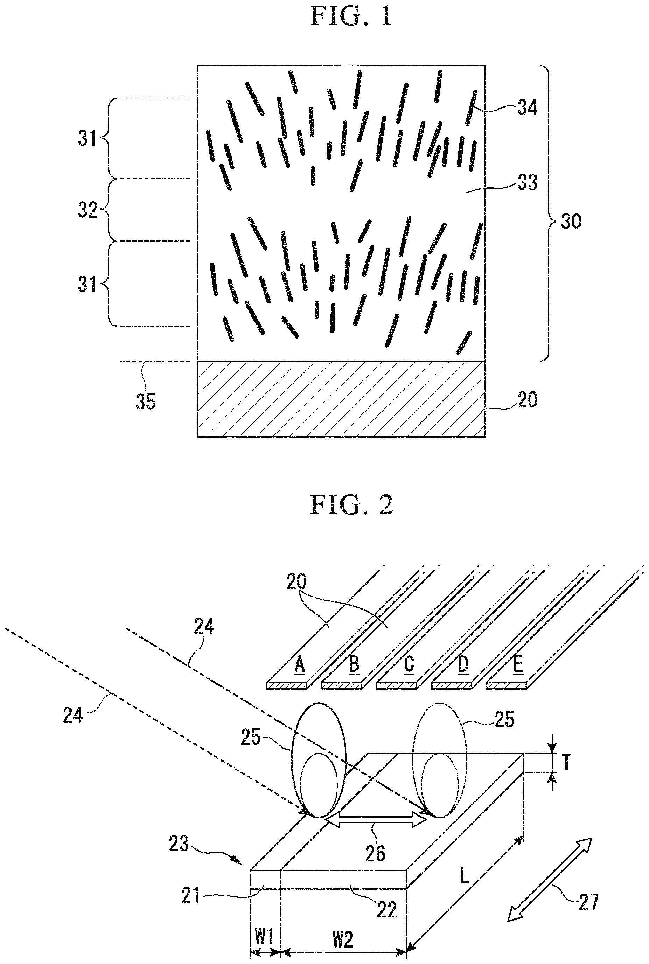

Hereinafter, a suitable embodiment of the present invention is described with reference to the drawings. FIG. 1 schematically shows an oxide superconducting wire of this embodiment. This oxide superconducting wire includes a superconducting layer 30 formed on a substrate 20. A substrate surface 35 is a surface of the substrate 20 on which the superconducting layer 30 is formed. In FIG. 1, the superconducting layer 30 is further enlarged in the thickness direction (the direction perpendicular to the substrate surface 35) than the actual size thereof in comparison with the substrate 20.

The superconducting layer 30 includes a structure in which a plurality of rod-shaped artificial pins (artificial pin rods 34) having different lengths are dispersed on a plane parallel to the substrate surface 35. In addition, the superconducting layer 30 includes a structure in which a layer (dense zone 31) having a high density of the artificial pin rods 34 in a plane parallel to the substrate surface 35 and a layer (sparse zone 32) having a low density of the artificial pin rods 34 in a plane parallel to the substrate surface 35 are alternately layered in the direction perpendicular to the substrate surface 35. Furthermore, in this embodiment, the plane parallel to the substrate surface 35 denotes a virtual plane (imaginary plane) positioned inside the superconducting layer 30 in parallel to the substrate surface 35.

The sparse zone 32 may be a layer formed only of a superconductor 33 or may be a layer containing, in the superconductor 33, the artificial pin rods 34 at a lower density than that of the dense zone 31. The layer in contact with the substrate 20 may be the dense zone 31 or the sparse zone 32. Two or more dense zones 31 and two or more sparse zones 32 may be alternately arranged in the thickness direction of the superconducting layer 30.

Although the border between the dense zone 31 and the sparse zone 32 is not certainly clear, it is preferable that the dense zone 31 include a plane whose density along a plane parallel to the substrate surface 35 is higher than that of the surroundings and the sparse zone 32 includes a plane whose density along a plane parallel to the substrate surface 35 is lower than that of the surroundings. Here, examples of the density along the plane include the number of artificial pin rods 34 per unit area (surface density). The structure in which the dense zone 31 and the sparse zone 32 are alternately layered includes, for example, a structure in which the density of the artificial pin rods 34 repeatedly increases and decreases in the direction perpendicular to the substrate surface 35. For example, a cross section (cross section in the thickness direction) of the superconducting layer 30 is observed by a transmission electron microscope (TEM), and the number of the artificial pin rods 34 per unit length in a line parallel to the substrate surface 35 is obtained, whereby the density can be calculated.

In the related art, in a case where a superconductor containing artificial pins is deposited in the direction perpendicular to the substrate surface through the gas phase method, the artificial pin rods to be introduced into a superconducting layer having the c-axis perpendicular to the substrate surface tend to grow in the c-axis direction of the superconductor. Therefore, as described above, there is an anisotropic problem that although a particularly strong pinning force is obtained when a magnetic field is applied in the c-axis direction, not much contribution to the pinning is obtained at other angles (magnetic field application angles). In this embodiment, since long artificial pin rods and short artificial pin rods are dispersed along a plane parallel to the substrate surface in a mixed state, the artificial pin rods having different lengths serve as pinning centers for magnetic fields having various application angles, and thus the anisotropic problem is solved. Furthermore, since the length of the artificial pin rods decreases, it is considered that the anisotropic problem is solved similar to that of the particulate pins. That is, for example, in a case where a magnetic field is applied to the superconducting layer in a direction orthogonal to the longitudinal direction of the artificial pin rods, if the length of the artificial pin rods is short, the area in which the line of magnetic flux passing through the artificial pin rod can move in the longitudinal direction is narrow, whereby appropriate pinning can be obtained.

The material (artificial pin material) forming the artificial pin rods 34 includes, for example, one or two or more of BaMO₃ (M is a tetravalent metal), Re₂O₃ (RE is a rare earth element), BaWO₄, ZrO₂, and the like. The tetravalent metal M includes Zr, Hf, Sn, Ti, and the like. The RE of Re₂O₃ includes, for example, Y, Gd, and the like. The length of the artificial pin rods 34 is, for example, 10 to 200 nm, and is preferably 50 nm or less. The thickness of the artificial pin rods 34 is, for example, 10 nm or less. It is preferable that the variation in length of the artificial pin rods 34 be large. When shown as the degree of dispersion such as standard deviation and quartile deviation, the degree of variation (degree of dispersion) in length of the artificial pin rods 34 in a plane parallel to the substrate surface 35 is, for example, 5 nm or more, 10 nm or more, 20 nm or more, or 30 nm or more.

As a method for controlling the length of the artificial pin rods, for example, Patent Document 2 discloses a method in which when the superconducting layer has a layered structure including a layer formed only of a superconducting substance and a superconducting layer having columnar crystals formed thereinside, the thickness of the superconductor layer having the columnar crystals formed thereinside is changed. However, by this method, the superconducting layer having columnar crystals whose lengths are equal along a plane parallel to the substrate surface is obtained. In this embodiment, the length of the artificial pin rods 34 has variation, and the lengths of the artificial pin rods 34 do not correspond to the thickness of the dense zone 31. In addition, the positions of both ends of each artificial pin rod 34 do also not correspond to the border lines between the dense zones 31 and the sparse zones 32.

FIG. 2 shows, as an example of a method for manufacturing the oxide superconducting wire of this embodiment, a film-forming process and a film-forming apparatus for forming the superconducting layer 30 as shown in FIG. 1 on the substrate 20. The substrate 20 of this embodiment is formed into a strip shape and can travel in the longitudinal direction of the substrate 20 in the film-forming process. In the film-forming process, as a target 23 used at the time of forming the superconducting layer on the substrate 20 through a pulsed laser deposition (PLD) method, two types of an artificial pin material-containing target 21 (first target) and a superconducting material target 22 (second target) are used. The artificial pin material-containing target 21 and the superconducting material target 22 may be integrally formed and juxtaposed or may be separately juxtaposed.

The artificial pin material-containing target 21 may contain a material (superconducting material) to form an oxide superconductor or may contain no superconducting material, as long as the artificial pin material-containing target 21 is a target containing an artificial pin material. It is also possible to change (increase and decrease) the concentration of the artificial pin material in the artificial pin material-containing target 21 continuously or stepwisely in, for example, a direction parallel to a surface thereof to be irradiated with the laser.

The superconducting material target 22 is a target containing a superconducting material and no artificial pin material. The superconducting material target 22 may be formed of a pure superconducting material (which may contain inevitable impurities). In addition, the meaning of the expression "the superconducting material target 22 contains no artificial pin material" includes a case where the superconducting material target 22 contains a trace of an artificial pin material, which can be regarded as a state of containing no artificial pin material, namely, a case where the artificial pin material is not substantially contained therein.

A laser 24 is caused to scan an irradiation position between the two targets 21 and 22, whereby the composition of a plume 25 released from the target 23 changes, and the composition of the superconducting layer deposited on the substrate 20 also changes. In addition, the position of the plume 25 with respect to the substrate 20 changes, whereby the length of the artificial pins easily has variation, and a structure in which the artificial pin rods having different lengths are dispersed can be easily obtained.

Although the number of scans is not particularly limited, scanning from either one of the targets 21 and 22 to the other thereof can be performed one time or two or more times. After scanning from one of the targets 21 and 22 to the other is performed, in a reverse manner, scanning from the other to the one of the targets 21 and 22 can be performed, and further the scanning can be repeated. It is preferable that the scanning speed be set such that the change in the scanning direction between the targets 21 and 22 is repeated two or more times during the film formation of the superconducting layer in the thickness direction. Here, the number of changes in the scanning direction between the targets 21 and 22 is counted as one time when the scanning is performed from one of the targets 21 and 22 to the other, and further is also counted as one time when the scanning is performed from the other to the one of the targets 21 and 22.

It is preferable that a portion of the substrate 20 pass over the target 23 a plurality of times in order to improve the film formation efficiency on the substrate 20. Accordingly, a plurality of lanes A to E may be provided in a direction (for example, the vertical direction, or the width direction of the substrate 20) crossing the traveling direction of the substrate 20, and the substrate 20 may be caused to travel so as to sequentially pass through the lanes A to E. For example, when passing through each lane in the order of A, B, C, D, and E, a portion of the substrate 20 passed through the lane A circulates through an area distant from the target 23 beyond the lanes and reaches the lane B, similarly, the traveling lane can be changed so as to pass through C after B, to pass through D after C, and to pass through E after D. Furthermore, after the film formation is performed while the substrate 20 passes in the order of A, B, C, D, and E, the film formation may be performed while the substrate 20 returns in the reverse order (the order of E, D, C, B, and A), and these processes may be repeated.

It is preferable that the direction (scanning direction 26) of scanning of the irradiation position by the laser 24 be a direction (for example, the vertical direction, or the width direction of the substrate 20) crossing the traveling direction of the substrate 20. In this case, the distance from the irradiation position of the laser 24 to the substrate 20 in each lane is changed, whereby the composition of the material to be deposited on the substrate 20 in each lane (namely, the composition of the plume 25 reaching the substrate 20) is easily changed, and it is expected to contribute to the variation in length of the artificial pin rods.

In the example of FIG. 2, at the time the substrate 20 is on the lane A-side of the lanes, a lot of the artificial pin material reaches the lane A-side when the laser 24 irradiates the artificial pin material-containing target 21, and the superconducting material does not easily reach the lane A-side when the laser 24 irradiates the superconducting material target 22, whereby many artificial pin rods easily grow, but the growth of some of the artificial pin rods may stop.

At the time the substrate 20 is in a lane C or in the vicinity thereof, the artificial pin material reaches the lane C or the vicinity thereof when the laser 24 irradiates the artificial pin material-containing target 21, and the superconducting material reaches the lane C or the vicinity thereof when the laser 24 irradiates the superconducting material target 22, whereby the growing artificial pin rods and the artificial pin rods whose growth stops can coexist in considerable proportions.

At the time the substrate 20 is on a lane E-side of the lanes, the artificial pin material does not easily reach the lane E-side when the laser 24 irradiates the artificial pin material-containing target 21, and a lot of the superconducting material reaches the lane E-side when the laser 24 irradiates the superconducting material target 22, whereby the growth of many artificial pin rods easily stops, but the growth of some of the artificial pin rods may continue.

As described above, according to the manufacturing method of this embodiment, it is possible to change the kind or the proportion of the material to be deposited on the substrate 20, or the degree of growth or growth stop of the artificial pin rods, for each lane. Accordingly, the length of the artificial pin rods, or the growth start position or the growth stop position in the thickness direction easily has variation, and it is possible to easily obtain a structure in which the artificial pin rods having different lengths are dispersed in each direction of the width direction, the length direction, and the thickness direction of the substrate 20.

If the film-forming process continues on the entire length in the longitudinal direction of the substrate 20, it is preferable to move the target 23 in a predetermined moving direction 27. Accordingly, the irradiation position of the laser 24 relatively moves on the target 23, and it is possible to uniformly consume the target 23. It is preferable that the moving direction 27 for uniformly using the target 23 cross (for example, be orthogonal to) the scanning direction 26 of the laser 24. The whole shape of the target 23 is not particularly limited, but the shape may be, for example, a rectangular shape having two sides extending in the scanning direction 26 and the moving direction 27.

In the two targets 21 and 22 shown in FIG. 2, an example is shown in which the lengths L thereof are equal to each other, the heights T thereof are equal to each other, and the width W1 of the target 21 and the width W2 of the target 22 are set so as to have a predetermined ratio, but the shape, the layout, and the like of each of the targets 21 and 22 can be arbitrarily set. For example, the position of and the number of the artificial pin material-containing target 21 in the target 23 is not particularly limited, but it may be positioned in either one end or each end on the lane A-side and the lane E-side of the lanes in the scanning direction 26 or in the intermediate position therebetween. Two or more artificial pin material-containing targets 21 and two or more superconducting material targets 22 can also be alternately arranged.

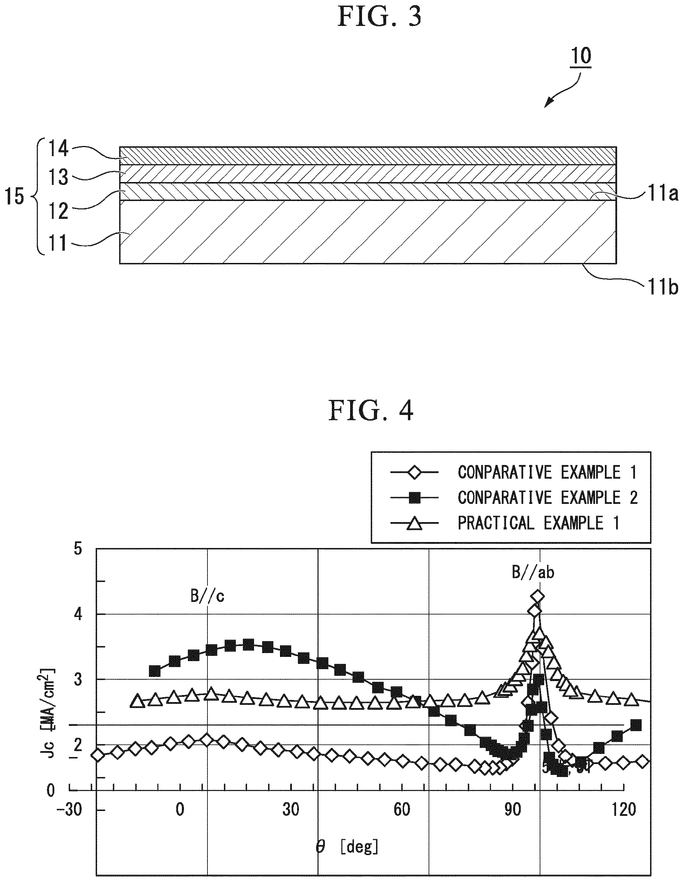

It is preferable that the substrate 20 be a layered body including one or two or more intermediate layers on a metal substrate. In addition, it is preferable to provide a protective layer on the superconducting layer 30. FIG. 3 shows, as an example of a superconducting wire 10, a layered body 15 including a metal substrate 11, an intermediate layer 12, an oxide superconducting layer 13 and a protective layer 14. When the layered body 15 of FIG. 3 is manufactured, the metal substrate 11 and the intermediate layer 12 can be used as the substrate 20, and the superconducting layer 30 can be film-formed as the oxide superconducting layer 13.

The metal substrate 11 is a tape-shaped metal substrate and has main surfaces (one surface 11a, and a back surface 11b reverse thereto) on both sides in the thickness direction thereof. A specific example of the metal forming the metal substrate 11 includes a nickel alloy represented by Hastelloy (registered trademark), stainless steel, a textured Ni-W alloy in which texture is introduced into a nickel alloy, and the like. The thickness of the metal substrate 11 may be appropriately adjusted according to the purpose and is within, for example, the range of 10 to 500 µm.

The intermediate layer 12 is provided between the metal substrate 11 and the oxide superconducting layer 13. The intermediate layer 12 may have a multilayer structure and may include, for example, a diffusion-preventing layer, a bed layer, a textured layer, a cap layer and the like, which are arranged from the metal substrate 11 to the oxide superconducting layer 13 in the listed order. Each one layer of these layers is not always provided, some of these layers may be omitted, or two or more layers of the same kind layer may be repeatedly provided.

The diffusion-preventing layer has a function of limiting a portion of the components of the metal substrate 11 from diffusing and entering the oxide superconducting layer 13 as impurities. The diffusion-preventing layer is formed of, for example, Si₃N₄, Al₂O₃, GZO (Gd₂Zr₂O₇), or the like. The thickness of the diffusion-preventing layer is, for example, 10 to 400 nm.

The textured layer is formed of a biaxially textured substance in order to control the crystal orientation property of the cap layer to be provided thereon. Examples of the material of the textured layer include a metal oxide such as Gd₂Zr₂O₇, MgO, ZrO₂-Y₂O₃ (YSZ), SrTiO₃, CeO₂, Y₂O₃, Al₂O₃, Gd₂O₃, Zr₂O₃, Ho₂O₃, and Nd₂O₃. It is preferable that the textured layer be formed through IBAD (Ion-Beam-Assisted Deposition) method.

The cap layer is film-formed on a surface of the above textured layer and is formed of a material in which crystal grains can self-orient in an in-plane direction (a direction parallel to the above surface). The material of the cap layer includes, for example, CeO₂, Y₂O₃, Al₂O₃, Gd₂O₃, ZrO₂, YSZ, Ho₂O₃, Nd₂O₃, LaMnO₃, and the like. The thickness of the cap layer may be within the range of 50 to 5000 nm.

The bed layer, which is a layer for reducing the interfacial reactivity and for obtaining the orientation property of a film to be formed thereon, may be formed on the diffusion-preventing layer. The material of the bed layer includes, for example, Y₂O₃, Er₂O₃, CeO₂, Dy₂O₃, Eu₂O₃, Ho₂O₃, La₂O₃, and the like. The thickness of the bed layer is, for example, 10 to 100 nm.

The oxide superconducting layer 13 is formed of an oxide superconductor containing a rare earth element. The oxide superconductor includes, for example, RE-Ba-Cu-O (REBCO) based oxide such as REBa₂Cu₃O_{X} (RE123). The rare earth element RE contained in the oxide superconductor includes one or two or more of Y, La, Ce, Pr, Nd, Sm, Eu, Gd, Tb, Dy, Ho, Er, Tm, Yb, and Lu. Among them, it is preferable to employ one of Y, Gd, Eu, and Sm or a combination of two or more of these elements. The thickness of the superconducting layer is, for example, about 0.5 to 5 µm. It is preferable that this thickness be constant with respect to the longitudinal direction of the superconducting wire 10.

The protective layer 14 has a function of bypassing an overcurrent generating at an accident, limiting a chemical reaction between the oxide superconducting layer 13 and a layer provided on the protective layer 14, or the like.

The material of the protective layer 14 includes, for example, silver (Ag), copper (Cu), gold (Au), an alloy of gold and silver, other silver alloys, copper alloys, gold alloys, and the like. The protective layer 14 covers at least the surface of the oxide superconducting layer 13 (the far-side surface of the oxide superconducting layer 13 from the metal substrate 11 in the thickness direction). Furthermore, the protective layer 14 may cover part or the entirety of areas selected from the side surface of the oxide superconducting layer 13, the side surface of the intermediate layer 12, the side surface and the back surface 11b of the metal substrate 11.

Although the present invention has been described based on the suitable embodiment, the present invention is not limited to the above embodiment, and various modifications can be employed within the scope of the present invention.

The superconducting wire 10 may include a stabilizing layer or a stabilizing material around the layered body 15. The material used for the stabilizing layer or the stabilizing material may be varied depending on the use of the superconducting wire 10. For example, in a case where the superconducting wire 10 is used for a superconducting cable, a superconducting motor, or the like, since it is necessary for the stabilizing layer or the stabilizing material to function as the main portion of a bypass through which an overcurrent generating at the transition to the normal conducting state flows, a good conductive metal is suitably used. The good conductive metal includes copper, copper alloy, aluminum, aluminum alloy, and the like. In addition, in a case where the superconducting wire 10 is used for a superconducting fault current limiter, since it is necessary to instantly limit an overcurrent generating at the transition to the normal conducting state, a high resistance metal is suitably used for the stabilizing layer or the stabilizing material. The high resistance metal includes, for example, Ni based alloy such as Ni-Cr.

The stabilizing layer can be layered by plating or the like and be formed on part or over the entirety of the periphery of the layered body 15, for example, on the protective layer 14. In addition, the stabilizing material may be formed of, for example, a tape-shaped metal member and can also be joined to the layered body 15 through a joining material. The material forming the joining material includes, for example, solder such as Sn-Pb type, Pb-Sn-Sb type, Sn-Pb-Bi type, Bi-Sn type, Sn-Cu type, Sn-Pb-Cu type, and Sn-Ag type, and metal such as Sn, Sn alloy, In (indium), In alloy, Ga, Ga alloy, Zn, and Zn alloy. In a case where the stabilizing material is formed of one or two or more metal tapes, one metal tape may cover only one surface of the periphery of the layered body 15, or may cover two or more surfaces of the periphery by folding.

Although there is no particular limitation on the method of providing the stabilizing material on the periphery of the layered body 15, there may be a method including a step of arranging the stabilizing material on the periphery of the layered body 15, a step of folding the stabilizing material along the outer shape of the layered body 15 (forming), a step of melting part or the entirety of the joining material by heating and pressurizing the layered body 15 (remelting, reflow), and a step of solidifying the joining material by cooling the entire layered body 15 while continuing the pressurization. There is no particular limitation on the method of supplying the joining material, and it may be formed to be layered on a surface of the stabilizing material or the like in advance, or may be added between the layered body 15 and the joining material or to the periphery thereof during processing.

The superconducting wire 10 can be used in various forms such as a tape shape, a cable shape, and a coil shape. When a superconducting coil is made of the superconducting wire 10, the superconducting wire 10 is wound around the outer circumferential surface of a spool by the number of required layers to be formed into a coil shape (multilayer wound coil), and thereafter the wound superconducting wire 10 is impregnated with a resin such as an epoxy resin so that the wound superconducting wire 10 is covered, whereby the superconducting wire 10 can be fixed. In addition, the superconducting wire 10 can include external terminals. A portion of the superconducting wire 10 provided with the external terminals may have a different cross-sectional structure from other portions.

In the method for manufacturing the oxide superconducting wire of this embodiment, since the substrate 20 sequentially travels in a plurality of lanes A, B, C, D, and E, the relative position between the substrate 20 and the target 23 is changed at the time the traveling of the substrate 20 in each lane is finished. This relative position is changed in an orthogonal direction (the left-right direction of FIG. 2) to each of the facing direction (the up-down direction of FIG. 2) between the substrate 20 and the target 23 and the longitudinal direction of the substrate 20. As the method of changing the relative position between the substrate 20 and the target 23, although the traveling lane of the substrate 20 is changed in this embodiment, the target 23 (and the irradiation range of the laser 24) may be moved in the above orthogonal direction each time the traveling of the substrate 20 in one lane is finished, thereby changing the relative position between the substrate 20 and the target 23.

In addition, it is possible to change the composition of the plume 25 by changing the irradiation range of the laser 24 in the scanning direction 26. For example, if the irradiation range of the laser 24 is set such that the artificial pin material-containing target 21 is irradiated in a wider range than the superconducting material target 22, the content rate of the artificial pin material in the generated plume 25 can be increased. On the other hand, if the irradiation range of the laser 24 is set such that the superconducting material target 22 is irradiated in a wider range than the artificial pin material-containing target 21, the content rate of the artificial pin material in the generated plume 25 can be decreased. Furthermore, for example, the irradiation range of the laser 24 may be changed in this way each time the traveling of the substrate 20 in one lane is finished, thereby changing the composition of the plume 25 and varying the growth of the artificial pin rods.

When the sparse zone 32 of the superconducting layer 30 is formed, the irradiation range of the laser 24 may be set to irradiate only the superconducting material target 22, or the irradiation area of the superconducting material target 22 may be set to be significantly greater than that of the artificial pin material-containing target 21.

### Examples

Hereinafter, the present invention is specifically described with reference to the examples. However, the present invention is not limited to these examples.

In Practical Example 1, as shown in FIG. 2, a juxtaposition-type target 23 was used, in which an artificial pin material-containing target 21 was formed of a BaHfO₃ sintered body having a width W1 = 20 mm, a length L = 200 mm, and a height T = 5 mm, and a superconducting material target 22 was formed of GdBCO having a width W2 = 140 mm, a length L = 200 mm, and a height T = 5mm.

In Comparative Example 1, a target formed of GdBCO (not containing BaHfO₃) was used.

In Comparative Example 2, a target in which 3.5 mol% of BaHfO₃ was uniformly mixed in GdBCO was used.

Using each target, a superconducting layer was film-formed on a substrate by the PLD method. The results of an evaluation of the magnetic field angle dependence of Jc of the obtained superconducting layer at a temperature of 50 K and an external magnetic field of 5 T are shown in the graph of FIG. 4. In Practical Example 1 in which the present invention was practiced, Jc is improved with respect to all magnetic field application angles θ. Comparing the values of the minimum Jc, Jc was about 2.6 MA/cm² in Practical Example 1, Jc was about 1.6 MA/cm² in Comparative Examples 1 and 2, and thus in Practical Example 1, an improvement in the minimum value of Jc was observed.

### Description of Reference Signs

- 10: superconducting wire
- 11: metal substrate
- 11a: one surface
- 11b: back surface
- 12: intermediate layer
- 13: oxide superconducting layer
- 14: protective layer
- 15: layered body
- 20: substrate
- 21: artificial pin material-containing target (first target)
- 22: superconducting material target (second target)
- 23: target
- 24: laser
- 25: plume
- 26: laser scanning direction
- 27: target moving direction
- 30: superconducting layer
- 31: dense zone
- 32: sparse zone
- 33: superconductor
- 34: artificial pin rod
- 35: substrate surface

## Claims

1. An oxide superconducting wire comprising:
a superconducting layer formed on a substrate,
wherein the superconducting layer includes a structure in which artificial pin rods having different lengths are dispersed on a plane parallel to a substrate surface of the substrate.

2. The oxide superconducting wire according to claim 1,
wherein the superconducting layer includes a structure in which a layer having a high density of the artificial pin rods in a plane parallel to the substrate surface and a layer having a low density of the artificial pin rods in a plane parallel to the substrate surface are alternately layered in a direction perpendicular to the substrate surface.

3. The oxide superconducting wire according to claim 1 or 2,
wherein the artificial pin rods are formed of BaMO₃ (M is a tetravalent metal) or Re₂O₃ (RE is a rare earth element).

4. A method for manufacturing the oxide superconducting wire according to any one of claims 1 to 3, the method comprising:
forming the superconducting layer on the substrate through a pulsed laser deposition (PLD) method by causing a laser to scan an irradiation position, in a direction crossing a traveling direction of the substrate, of a first target and a second target integrally or separately juxtaposed, the first target containing a material to form the artificial pin rods, the second target containing a material to form an oxide superconductor and no material to form the artificial pin rods.
